# FASCICULE DE BREVET EUROPEEN

(11) **EP 4 544 683 B1**
(45) Date de publication et mention de la délivrance du brevet: **20.05.2026**
(21) Numéro de dépôt: 23744202.5
(22) Date de dépôt: 19.06.2023
(51) Int. Cl.: H03K 17/14, G05F 3/24, H03K 17/687

(54) **CIRCUIT DE REFERENCE DE TENSION**
SPANNUNGSREFERENZSCHALTUNG
VOLTAGE REFERENCE CIRCUIT

(30) Priorité: 23.06.2022 FR 2206270
(43) Date de publication de la demande: 30.04.2025
(73) Titulaire: Wise-Integration, 83400 Hyeres (FR)
(72) Inventeur: BERGOGNE, Dominique, 43140 SAINT-DIDIER-EN-VELAY (FR); GAVIRIA DUQUE, Sebastian, 38000 GRENOBLE (FR); BAU, Plinio, 38400 SAINT-MARTIN-D'HERES (FR)
(74) Mandataire: Ipsilon
(86) Numéro de dépôt international: PCT/FR2023/050908
(87) Numéro de publication internationale: WO 2023/247880

(56) Documents cités:
- EP-A2- 0 183 185
- US-A- 4 727 309
- US-A1- 2020 257 325

## Description

### DOMAINE TECHNIQUE

L'invention se rapporte au domaine des circuits de référence de tension utilisés dans les circuits intégrés.

L'invention concerne en particulier un circuit de référence de tension présentant une structure plus compacte et permettant de fournir une référence de tension constante même lorsque la source d'alimentation, la température ou les paramètres des composants varient.

### ETAT DE LA TECHNIQUE

De manière classique, les circuits de référence de tension sont des circuits qui fournissent une tension de référence stable et constante dans le temps. Il est d'ailleurs recherché d'obtenir une tension de référence insensible aux variations de certains paramètres.

A titre d'exemple, ces paramètres sont par exemple la tension d'alimentation, la température, les dispersions de fabrication ou encore le vieillissement des composants.

En particulier, on retrouve souvent des transistors dans les circuits de référence de tension. Or, les paramètres d'un transistor donné peuvent grandement varier en fonction de leur processus de fabrication. Plus encore, deux transistors résultant du même processus de fabrication peuvent être largement différents en fonction du positionnement qu'ils ont sur la plaque de semiconducteur ayant servi à leur fabrication.

L'un de ces paramètres est la valeur seuil de tension à partir de laquelle un canal se forme entre le drain et la source d'un transistor donné. Cette valeur minimum est celle à appliquer entre la grille et la source, afin de conduire un courant électrique entre le drain et la source dudit transistor donné. Ce paramètre peut varier jusqu'à 50% d'un transistor à un autre, ce qui peut entrainer une perte de stabilité de la référence de tension du circuit.

Un circuit de référence de tension comporte généralement deux types de transistors : les transistors à appauvrissement et les transistors à enrichissement.

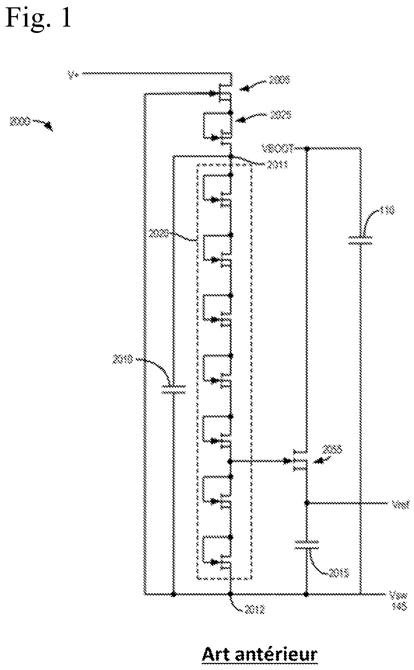

Tel qu'illustré sur la figure 1 de l'art antérieur, un transistor à appauvrissement **2005** est communément symbolisé avec un trait continu reliant le drain, la source et la base. Un transistor à enrichissement **2025** est communément symbolisé avec une ligne discontinue reliant le drain, la source et la base.

A titre d'exemple, tel qu'illustré à la figure 1 extraite du document US 9,647.476 B2, un circuit de référence de tension **2000** comporte généralement un transistor à appauvrissement **2005** dont le drain est connecté à une source de tension **V+** et dont la source est connectée avec huit transistors à enrichissement **2025** en série. Chaque transistor à enrichissement **2025** a sa grille reliée à son drain et le dernier transistor à enrichissement de la série a sa source connectée à la masse. La grille du transistor à appauvrissement **2005** est également connectée à la masse. La tension de référence **Vref** est mesurée entre un point situé entre un condensateur **2015** et la source d'un transistor à enrichissement **2055** dont la grille est connectée entre le sixième et le septième transistor à appauvrissement de la série.

Dans cette configuration, le circuit de référence de tension **2000** permet d'obtenir une consommation faible en courant, typiquement inférieure à 1µA. Cependant, un tel circuit ne permet pas d'atteindre de hautes valeurs de tension de référence. En outre, ce type de montage est sensible aux variations de paramètres des transistors, et notamment la tension de référence présente des instabilités.

Selon un autre exemple, la publication « A 23.6ppm/°C Monolithically Integrated GaN Reference Voltage Design with Temperature Range from -50°C to 200°C and Supply Voltage Range from 3.9 to 24V » de Cheng-Hsing Liao et al. décrit plusieurs modes de réalisation de circuits de référence de tension.

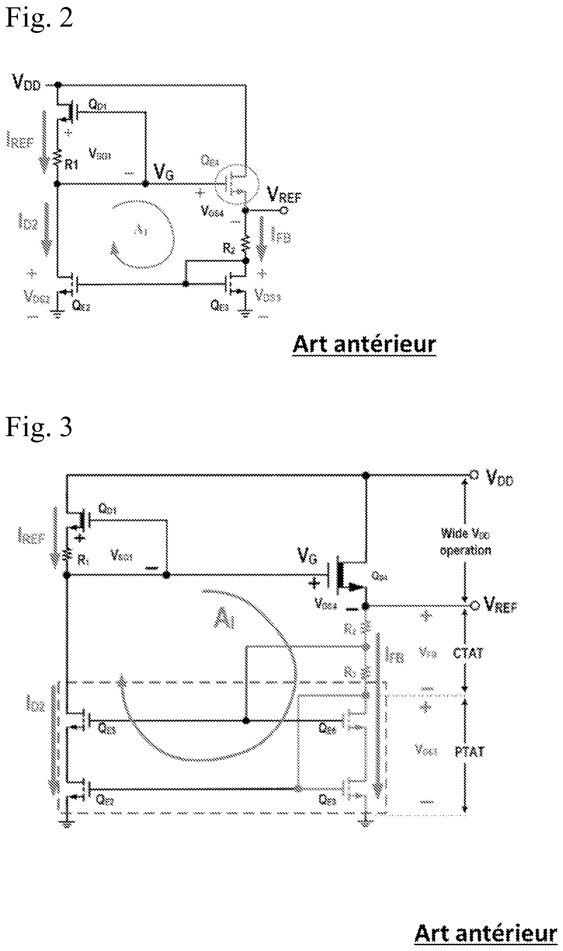

La figure 2 illustre l'un de ces modes de réalisation, dans lequel le circuit de référence de tension comporte une première branche incluant un transistor à appauvrissement **QD1** dont le drain est connecté à une source de tension **VDD,** dont la source est connectée à une première borne d'une résistance **R1** et dont la grille est connectée à la seconde borne de la résistance **R1.**

La seconde borne de la résistance **R1** est également connectée au drain d'un transistor à enrichissement **QE2,** dont la source est connectée à la masse.

Le circuit de référence de tension de la figure 2 comporte également une seconde branche incluant un premier transistor à enrichissement **QE4** dont le drain est connecté à la source de tension **VDD** et dont la source est connectée à une première borne d'une résistance **R2.**

La seconde borne de la résistance **R2** est connectée au drain d'un second transistor à enrichissement **QE3,** dont la grille est connectée à son drain et dont la source est connectée à la masse.

Les première et seconde branches sont interconnectées de sorte que la grille du transistor à appauvrissement **QD1** de la première branche est connecté à la grille du premier transistor à enrichissement **QE4** de la seconde branche. De plus, la grille du transistor à enrichissement **QE2** de la première branche et connecter à la grille du transitoire à enrichissement **QE3** de la seconde branche, de sorte à former un miroir de courant.

La tension de référence **Vref** est prise au niveau de la source du transistor à enrichissement **QE4.**

La figure 3 illustre un deuxième mode de réalisation décrit dans la publication de Cheng-Hsing Liao et al. citée plus haut. Le circuit présente la même architecture que celle décrite à la figure 2. Le circuit comporte cependant des composants supplémentaires. La première branche comporte un transistor à enrichissement supplémentaire **QE5,** dont le drain est connecté à la source du transistor à enrichissement **QE2** et dont la source est connectée à la masse.

La seconde branche comporte une résistance supplémentaire **R2** connectée entre la résistance **R2** et le drain du transistor à enrichissement **QE2** et un transistor à enrichissement supplémentaire **QE6,** dont le drain est connecté à la source du transistor à enrichissement **QE3** et dont la source est connectée à la masse.

La grille du transistor **QE6** est connectée d'une part à la grille du transistor **QE5** et d'autre part au drain du transistor **QE3.**

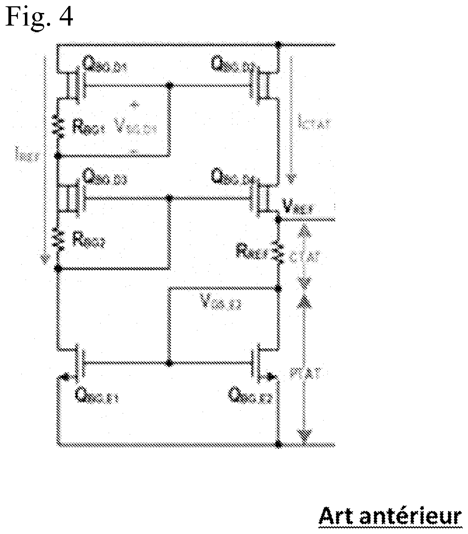

La figure 4 illustre un autre circuit de référence de tension décrit dans la publication de Cheng-Hsing Liao et al. citée plus haut, dans lequel le circuit de référence de tension comportant une première branche incluant un premier transistor à appauvrissement **QSG,D1** dont le drain est connecté à une source de tension **VDD,** dont la source est connectée à une première borne d'une première résistance **RSG1** et dont la grille est connectée à la seconde borne de la première résistance **RSG1.** La première branche inclut également un second transistor à appauvrissement **QSG,D3,** dont le drain est connecté à la seconde borne de la première résistance **RSG1,** dont la source est connectée à une première borne d'une seconde résistance **RSG2** et dont la grille est connectée à la seconde borne de la résistance **RSG2.**

Le drain du second transistor à appauvrissement **QSG,D3** est également connecté au drain d'un transistor à enrichissement **QSG,E1,** dont la source est connectée à la masse.

Le circuit de la figure 4 inclut également une seconde branche comportant un premier transistor à appauvrissement **QSG,D2** dont le drain est connecté à la source de tension **VDD.** Le premier transistor à appauvrissement **QSG,D2** est connecté, par sa source, au drain d'un second transistor à appauvrissement **QSG,D4.** La source du second transistor à appauvrissement **QSG,D4** est connectée à une première borne d'une troisième résistance **RREF,** dont la seconde borne est connectée au drain d'un transistor à enrichissement **QSG,E2.** La source du transistor à enrichissement **QSG,E2** est connectée à la masse, tandis que la grille du transistor à enrichissement **QSG,E2** est connectée à son drain.

Les première et seconde branches sont connectées entre-elles au niveau des transistors à appauvrissement **QSG,D1** et **QSG,D2,** dont les grilles sont reliées. De même, les transistors à appauvrissement **QSG,D3** et **QSG,D4** ont leurs grilles connectées. Enfin, les grilles des transistors à enrichissement **QSG,E1** et **QSG,E2** sont également connectées entre-elles.

La tension de référence **Vref** est prise au niveau de la source du transistor à appauvrissement **QSG,D4.**

Bien qu'étant plus stables que le circuit de la figure 1, les circuits décrits aux figures 2 à 4 comportent des résistances **R1, RSG1, RSG2** utilisées pour fixer le courant. Cette méthode est usuellement très efficace du fait du comportement linéaire de la résistance. Cependant, pour limiter la consommation énergétique, ces résistances doivent être suffisamment grandes, ce qui signifie qu'elles occupent également une grande surface de semiconducteur. Ainsi, il est difficile d'incorporer de telles résistances dans des circuits intégrés, d'autant plus lorsqu'il est recherché d'en limiter au maximum la surface.

Les publications EP 0 183 185 A2, US 2020/257325 A1 et US 4 727 309 A divulguent des circuits de référence de tension faisant partie de l'art antérieur.

Le problème que se propose de résoudre l'invention est d'obtenir un circuit de référence de tension stable, notamment vis-à-vis des variations de procédé de fabrication des transistors, tout en limitant la consommation du circuit, ainsi que la place qu'il occupe.

### EXPOSE DE L'INVENTION

Pour résoudre ce problème, le Demandeur a mis au point un circuit de référence de tension comportant :
- une première branche comprenant :
   - un premier transistor de tête à appauvrissement dont le drain est connecté à une source de tension,
   - un premier transistor de pied à enrichissement dont la source est connectée à la masse, dont le drain est connecté, d'une part, à la grille du transistor de tête, et d'autre part à la grille dudit transistor de pied, et
   - un dipôle dont une première borne est connectée à la source du transistor de tête et dont la seconde borne est connectée au drain du transistor de pied, et
- une seconde branche comprenant :
   - un second transistor de tête à appauvrissement dont le drain est connecté à la source de tension, dont la source est connectée au drain d'un troisième transistor à appauvrissement et dont la grille est connectée à la source dudit troisième transistor à appauvrissement, et
   - un second transistor de pied à enrichissement dont la source est connectée à la masse et dont le drain est connecté à la source du troisième transistor à appauvrissement,
la source du premier transistor de tête de la première branche étant connectée à la grille du troisième transistor à appauvrissement de la seconde branche, les grilles du premier transistor de pied de la première branche et du second transistor de pied de la seconde branche étant connectée de sorte à former un miroir de courant, la tension de référence étant fournie au niveau de la source du second transistor de tête de la seconde branche.

Un tel circuit présente très peu de composants en comparaison du circuit de l'art antérieur de la figure 1. En comparaison des circuits des figures 2 à 4, le circuit de l'invention comporte sensiblement le même nombre de composants et, dans une variante, peut avantageusement ne comporter aucune résistance. Il occupe ainsi une surface moindre en comparaison de l'art antérieur et est plus facile à intégrer dans des circuits aux dimensions réduites. De plus, moins de parasites, lié à l'interactions des composants entre eux, apparaissent sur le signal de référence de tension, du fait du nombre limité de composants. En plus d'être plus compact, le circuit de l'invention présente des performances améliorées par rapport aux circuits de l'art antérieur, notamment au niveau de la stabilité en température.

Selon un premier mode de réalisation, le dipôle est un transistor à enrichissement dont le drain est connecté, d'une part, à la grille dudit transistor à enrichissement, et d'autre part, à la première borne du dipôle, et dont la source est connectée à la seconde borne du dipôle.

Un transistor dont la grille est connectée à son drain se comporte quasiment comme une diode. Le dimensionnement du transistor n'a en principe pas d'incidence importante sur la valeur de la référence de tension. Cependant, le dimensionnement peut être adapté afin de limiter la consommation énergétique du circuit de référence de tension.

Ce mode de réalisation est le plus simple. Le circuit ne comprend que trois transistors à appauvrissement et quatre transistors à enrichissement, soit sept composants au total. Un tel circuit est donc particulièrement aisé à mettre en œuvre dans des circuits intégrés aux dimensions réduites.

Selon un deuxième mode de réalisation, le dipôle comporte n transistors à enrichissement, chacun desdits transistors à enrichissement ayant sa grille connectée à son drain, lesdits transistors à enrichissement étant connectés en série, deux transistors consécutifs étant connectés par la source de l'un et le drain de l'autre et, le drain du premier transistor formant la première borne du dipôle et la source du dernier transistor formant la seconde borne du second dipôle.

Le nombre de transistors à enrichissement montés en diode contenus dans le dipôle est choisi de sorte à réaliser un compromis entre consommation énergétique et surface occupée. En effet, plus le nombre de transistors à enrichissement montés en diode est important et plus la consommation énergétique du circuit est abaissée, mais à l'inverse, le circuit occupe alors plus de place.

Selon un mode de réalisation privilégié, le dipôle comporte trois transistors à enrichissement.

Ce mode de réalisation représente un compromis intéressant entre consommation énergétique et surface occupée. Dans ce mode de réalisation, le circuit de référence de tension comporte un ratio du nombre de transistors à appauvrissement sur le nombre de transistors à enrichissement sensiblement égal à deux, ce qui permet de compenser les variations de la valeur seuil définie précédemment. En effet, pour des transistors à canal N, les transistors à appauvrissement présentent une valeur seuil négative, tandis que les transistors à appauvrissement présentent une valeur seuil positive. En outre, la valeur absolue de la valeur seuil d'un transistor à enrichissement est sensiblement égale au double de la valeur seuil d'un transistor à appauvrissement. Ainsi, un transistor à enrichissement permet de compenser une paire de transistors à appauvrissement. Les valeurs seuil se compensent, voire s'annulent, ce qui permet de limiter les effets délétères sur la valeur de la tension de référence.

En pratique, l'invention trouve une application particulièrement avantageuse pour les transistors pour lesquels il n'existe pas de transistor complémentaire, c'est-à-dire lorsqu'une seule polarité existe, comme le type N dans le GaN, avec la double possibilité de dispositifs à enrichissement et à déplétion, tels que les transistors de type GaN, ou les transistors NMOS. Cependant l'invention est aussi valable pour des technologies à transistors complémentaires comme les transistors bipolaires NPN ou PNP et les transistors CMOS de type N ou P.

### DESCRIPTION DES FIGURES

La manière de réaliser l'invention, ainsi que les avantages qui en découlent, ressortiront bien de la description des modes de réalisation qui suivent, à l'appui des figures annexées dans lesquelles :
[Fig 1] La figure 1 est un premier schéma électrique d'un circuit de référence de tension de l'art antérieur,
[Fig 2] La figure 2 est un deuxième schéma électrique d'un circuit de référence de tension de l'art antérieur,
[Fig 3] La figure 3 est un troisième schéma électrique d'un circuit de référence de tension de l'art antérieur,
[Fig 4] La figure 4 est un quatrième schéma électrique d'un circuit de référence de tension de l'art antérieur,
[Fig 5] La figure 5 est un schéma électrique du circuit de référence de tension selon un premier mode de réalisation de l'invention,
[Fig 6] La figure 6 est un schéma électrique du circuit de référence de tension selon un deuxième mode de réalisation de l'invention,
[Fig 7] La figure 7 est un schéma électrique du circuit de référence de tension selon un troisième mode de réalisation de l'invention,
[Fig 8] La figure 8 est un tableau comparatif des performances des circuits de référence de l'état de la technique des figures 2 à 4 et du circuit de l'invention illustré à la figure 5.
[Fig 9] La figure 9 est un graphique comparatif de l'évolution de la tension de référence en fonction de la température pour le circuit de l'invention illustré à la figure 5 et pour le circuit de l'état de la technique de la figure 4, et
[Fig 10] La figure 10 est un graphique comparatif de l'évolution de la tension de référence en fonction de la tension d'alimentation pour des transistors théoriquement identiques mais dont les paramètres intrinsèques diffèrent à cause des tolérances de fabrication, pour le circuit de l'invention illustré à la figure 5 et pour le circuit de l'état de la technique de la figure 4.

### DESCRIPTION DETAILLEE DES MODES DE REALISATION

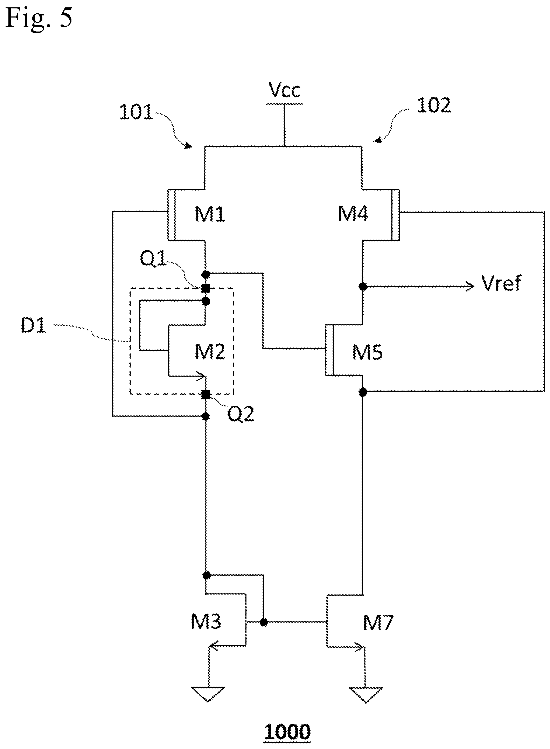

Tel qu'illustré sur les figures 5 à 7, le circuit de référence de tension de l'invention comporte deux branches **101, 102.**

La première branche **101** comporte un premier transistor de tête à appauvrissement **M1** dont le drain est connecté à une source de tension **Vcc.** La source de tension **Vcc** fournit de préférence une tension continue pouvant varier en fonction du courant fournit ou en fonction du temps, et par exemple comprise entre 4 et 12 V.

La première branche **101** comporte également un premier transistor de pied à enrichissement **M3** dont la source est connectée à la masse.

Les deux premiers transistors de tête **M1** et de pied **M3** sont reliés l'un à l'autre par l'intermédiaire d'un dipôle **D1, D11, D21** présentant avantageusement un comportement résistif, linéaire ou non. A titre d'exemple, le dipôle **D1, D11, D21** est soit une résistance, soit une diode, soit un transistor monté en diode, comportant deux bornes **Q1, Q11, Q21** et **Q2, Q12, Q22.** Le dipôle **D1, D11, D21** permet de polariser le transistor de tête **M1.**

Ainsi, le premier transistor de tête **M1** est connecté, par sa source, à la première borne **Q1, Q11, Q21** du dipôle **D1, D11, D21,** tandis que le premier transistor de pied **M3** est connecté, par son drain, à la seconde borne **Q2, Q12, Q22** du dipôle **D1, D11, D21.**

En outre, le drain du premier transistor de pied **M3** est également connecté, d'une part, à la grille du premier transistor de tête **M1**, et d'autre part, à sa propre grille.

Dans le mode de réalisation de la figure 5, le dipôle **D1** correspond à un transistor à enrichissement **M2,** monté en diode, c'est-à-dire que sa grille est connectée à son drain. Ainsi, le drain du transistor à enrichissement **M2** correspond à la première borne **Q1** du dipôle **D1** et la source du transistor à enrichissement **M2** correspond à la seconde borne **Q2** du dipôle **D1.**

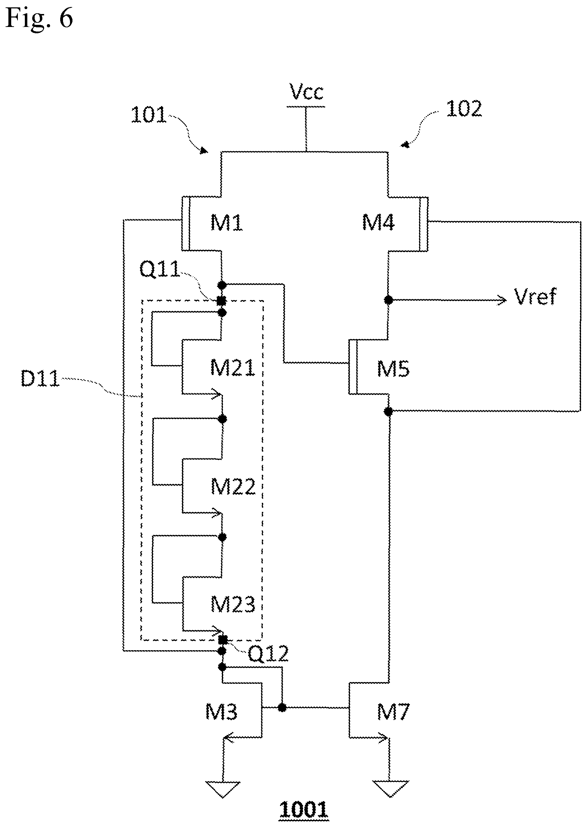

Dans le mode de réalisation de la figure 6, le dipôle **D11** correspond à trois transistors à enrichissement **M21, M22, M23** connectés en série. Les trois transistors **M21, M22, M23** sont montés en en diode. Ainsi, le drain du transistor à enrichissement **M21** correspond à la première borne **Q11** du dipôle **D11.** La source du transistor à enrichissement **M21** est connecté au drain du transistor à enrichissement **M22** et la source du transistor à enrichissement **M22** est connectée au drain du transistor à enrichissement **M23.** Enfin, la source du transistor à enrichissement **M23** correspond à la seconde borne **Q12** du dipôle **D11.**

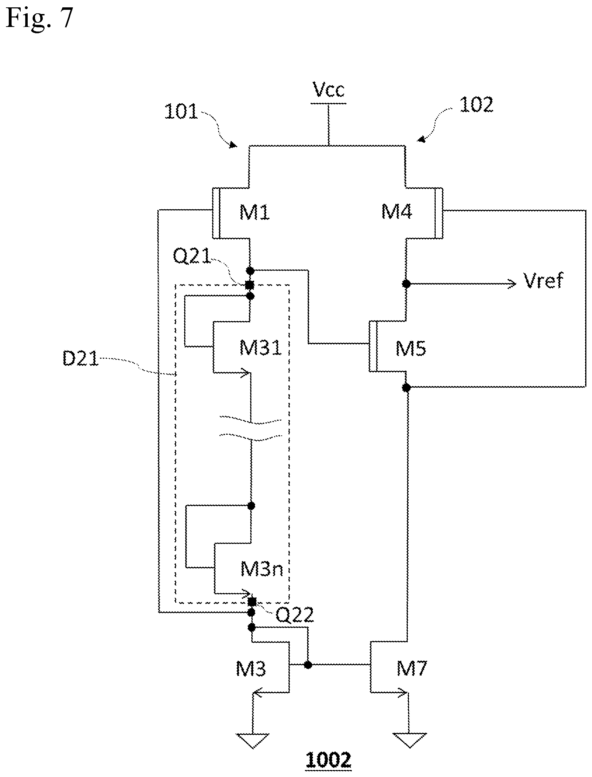

Dans le mode de réalisation de la figure 7, le dipôle **D21** correspond à n transistors à enrichissement **M31-M3n** connectés en série. Chaque transistor à enrichissement **M31-M3n** est monté en en diode. Ainsi, le drain du transistor à enrichissement **M31** correspond à la première borne **Q21** du dipôle **D21** et la source du transistor à enrichissement **M3n** correspond à la seconde borne **Q22** du dipôle **D21.** Deux transistors consécutifs sont connectés par la source de l'un et le drain de l'autre.

La seconde branche **102** comporte un second transistor de tête à appauvrissement **M4,** dont le drain est connecté à la source de tension **Vcc.**

La seconde branche **102** comporte également un second transistor de pied à enrichissement **M7,** dont la source est connectée à la masse.

Les seconds transistors de tête **M4** et de pied **M7** sont reliés entre eux par l'intermédiaire d'un troisième transistor à appauvrissement **M5.**

Ainsi, le troisième transistor à appauvrissement **M5** est connecté, par son drain, à la source du second transistor de tête **M4,** et par sa source, au drain du second transistor de pied **M7.**

Les première et seconde branches **101, 102** sont interconnectées à deux endroits.

En effet, la source du premier transistor de tête **M1,** de la première branche **101** est connectée à la grille du troisième transistor à appauvrissement **M5** de la seconde branche **102.**

De même, les grilles des premier et second transistors de pied **M3** et **M7** sont connectées entre-elles, de sorte à former un miroir de courant. Ainsi, le courant traversant le premier transistor de pied **M3** est recopié dans le second transistor de pied **M7.**

La valeur de référence de tension **Vref** est mesurée au niveau de la source du second transistor de tête **M4** et par rapport à la masse.

Les transistors peuvent appartenir à la catégorie des transistors N de type GaN ou MOS. Ces catégories de transistors peuvent présenter une valeur seuil négative, ce qui permet de compenser les variations de processus de fabrication, également appelés « corner » dans la littérature anglosaxonne.

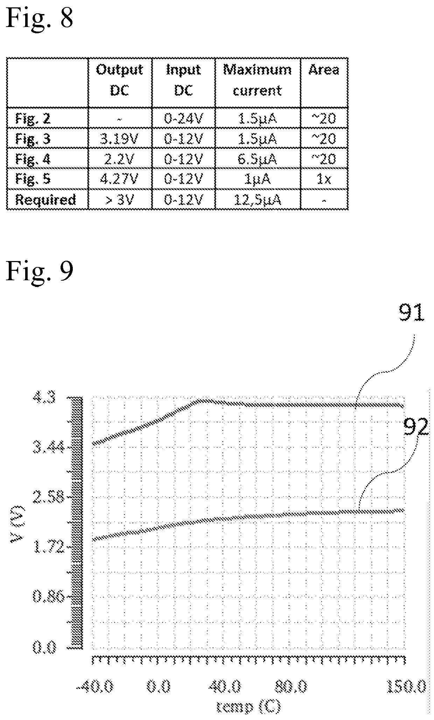

La figure 8 illustre un tableau comparatif des performances des circuits de référence de tension des figures 2 à 4 et du circuit de l'invention de la figure 5.

Ainsi, on remarque dans un premier temps que la surface occupée par les circuits de l'art antérieur est environ 20 fois supérieure à la surface occupée par le circuit de l'invention. Le circuit de l'invention est donc très compact, pour des performances comparables, voire améliorée sur certains points. En effet, le circuit de l'invention consomme un courant maximal plus faible que les circuits de l'art antérieur, typiquement égal à 1µA.

En outre, le circuit de l'invention présente une plus faible variation vis-à-vis de la température en comparaison des circuits de l'état de la technique. Des mesures ont été réalisées par le Demandeur afin de comparer les performances obtenues entre le circuit de l'invention et un circuit de l'état de la technique.

Tel qu'illustré sur la figure 9, entre 25 et 150°C, la tension de référence de l'invention **91** varie d'environ 1%, tandis que la tension de référence **92** du circuit de l'art antérieur de la figure 4 varie d'environ 11,9%. La sensibilité à la température du circuit de l'invention est donc abaissée d'un facteur 12 et le circuit est plus robuste.

Le circuit de référence de tension obtenu est par ailleurs peu sensible aux fluctuations de la tension d'alimentation, de la température et des variations de procédé de fabrication des transistors.

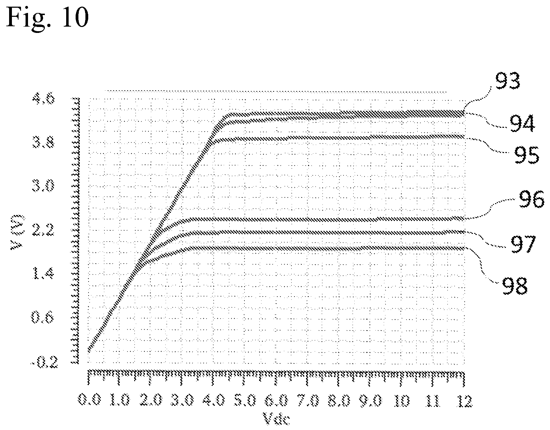

La figure 10 compare les variations de la tension de référence **Vref** pour des transistors théoriquement identiques, mais dont les paramètres intrinsèques diffèrent à cause des tolérances de fabrication.

Pour le circuit de l'état de la technique **93-95** illustré à la figure 4, on remarque que pour une tension d'alimentation supérieure à 4V, la tension de référence **Vref** mesurée pour les transistors varie de 12.4%, tandis que pour le circuit de l'invention **96-98** illustré à la figure 5, elle varie de 5.4%, plus de deux fois moins.

Pour conclure, l'invention permet d'obtenir un circuit de référence de tension stable, notamment vis-à-vis des variations de procédé de fabrication des transistors et de la température, tout en limitant la consommation du circuit, ainsi que la place qu'il occupe.

## Revendications

1. Circuit de référence de tension (1000, 1001, 1002) comportant :
- une première branche (101) comprenant :
• un premier transistor de tête à appauvrissement (M1) dont le drain est connecté à une source de tension (Vcc),
• un premier transistor de pied à enrichissement (M3) dont la source est connectée à la masse, dont le drain est connecté, d'une part, à la grille du transistor de tête (M1), et d'autre part à la grille dudit transistor de pied (M3), et
• un dipôle (D1, D11, D21) dont une première borne (Q1, Q11) est connectée à la source du transistor de tête (M1) et dont la seconde borne (Q2, 21) est connectée au drain du transistor de pied (M3), et
- une seconde branche (102) comprenant :
• un second transistor de tête à appauvrissement (M4) dont le drain est connecté à la source de tension (Vcc), dont la source est connectée au drain d'un troisième transistor à appauvrissement (M5) et dont la grille est connectée à la source dudit troisième transistor à appauvrissement (M5), et
• un second transistor de pied à enrichissement (M7) dont la source est connectée à la masse et dont le drain est connecté à la source du troisième transistor à appauvrissement (M5),
la source du premier transistor de tête (M1) de la première branche (101) étant connectée à la grille du troisième transistor à appauvrissement (M5) de la seconde branche (102), les grilles du premier transistor de pied (M3) de la première branche (101) et du second transistor de pied (M7) de la seconde branche (102) étant connectée de sorte à former un miroir de courant, la tension de référence (Vref) étant fournie au niveau de la source du second transistor de tête (M4) de la seconde branche (102).

2. Circuit de référence de tension selon la revendication 1, ***caractérisé en ce que*** le dipôle (D1) est un transistor à enrichissement (M2) dont le drain est connecté, d'une part, à la grille dudit transistor à enrichissement (M2), et d'autre part, à la première borne (Q1) du dipôle (D1), et dont la source est connectée à la seconde borne (Q2) du dipôle (D1).

3. Circuit de référence de tension selon la revendication 1, ***caractérisé en ce que*** le dipôle (D21) comporte n transistors à enrichissement (M31, M3n), chacun desdits transistors à enrichissement (M31-M3n) ayant sa grille connectée à son drain, lesdits transistors à enrichissement (M31-M3n) étant connectés en série, deux transistors (M31-M3n) consécutifs étant connectés par la source de l'un et le drain de l'autre et, le drain du premier transistor (M31) formant la première borne (Q21) du dipôle (D21) et la source du dernier transistor (M3n) formant la seconde borne (Q22) du second dipôle (D21).

4. Circuit de référence de tension selon la revendication 4, ***caractérisé en ce que*** le dipôle (D11) comporte trois transistors à enrichissement (M21, M22, M23).

5. Circuit de référence de tension selon la revendication 1, ***caractérisé en ce que*** les transistors sont des transistors GaN.

## Patentansprüche

1. Spannungsreferenzschaltung (1000, 1001, 1002), umfassend:
- einen ersten Zweig (101), umfassend:
• einen ersten Verarmungs-Kopftransistor (M1), dessen Drain mit einer Spannungsquelle (Vcc) verbunden ist,
• einen ersten Anreicherungs-Fußtransistor (M3), dessen Source mit der Masse verbunden ist, dessen Drain einerseits mit dem Gate des Kopfransistors (M1) und andererseits mit dem Gate des Fußtransistors (M3) verbunden ist, und
• einen Dipol (D1, D11, D21), dessen erster Anschluss (Q1, Q11) mit der Source des Kopftransistors (M1) verbunden ist und dessen zweiter Anschluss (Q2, 21) mit dem Drain des Fußtransistors (M3) verbunden ist, und
- einen zweiten Zweig (102), umfassend:
• einen zweiten Verarmungs-Kopftransistor (M4), dessen Drain mit der Spannungsquelle (Vcc) verbunden ist, dessen Source mit dem Drain eines dritten Verarmungstransistors (M5) verbunden ist und dessen Gate mit der Source des dritten Verarmungstransistors (M5) verbunden ist, und
• einen zweiten Anreicherungs-Fußtransistor (M7), dessen Source mit der Masse verbunden ist und dessen Drain mit der Source des dritten Verarmungstransistors (M5) verbunden ist,
wobei die Source des ersten Kopftransistors (M1) des ersten Zweigs (101) mit dem Gate des dritten Verarmungstransistors (M5) des zweiten Zweigs (102) verbunden ist, wobei die Gates des ersten Fußtransistors (M3) des ersten Zweigs (101) und des zweiten Fußtransistors (M7) des zweiten Zweigs (102) so verbunden sind, dass sie einen Stromspiegel bilden, wobei die Referenzspannung (Vref) an der Source des zweiten Kopftransistors (M4) des zweiten Zweigs (102) bereitgestellt wird.

2. Spannungsreferenzschaltung nach Anspruch 1, ***dadurch gekennzeichnet, dass*** es sich bei dem Dipol (D1) um einen Anreicherungstransistor (M2) handelt, dessen Drain einerseits mit dem Gate des Anreicherungstransistors (M2) und andererseits mit dem ersten Anschluss (Q1) des Dipols (D1) verbunden ist und dessen Source mit dem zweiten Anschluss (Q2) des Dipols (D1) verbunden ist.

3. Spannungsreferenzschaltung nach Anspruch 1, ***dadurch gekennzeichnet, dass*** der Dipol (D21) n Anreicherungstransistoren (M31, M3n) umfasst, wobei bei jedem dieser Anreicherungstransistoren (M31-M3n) das Gate mit dem Drain verbunden ist und die Anreicherungstransistoren (M31-M3n) in Reihe geschaltet sind, wobei zwei aufeinanderfolgende Transistoren (M31-M3n) über die Source des einen und den Drain des anderen verbunden sind und der Drain des ersten Transistors (M31) den ersten Anschluss (Q21) des Dipols (D21) bildet und die Source des letzten Transistors (M3n) den zweiten Anschluss (Q22) des zweiten Dipols (D21) bildet.

4. Spannungsreferenzschaltung nach Anspruch 4, ***dadurch gekennzeichnet, dass*** der Dipol (D11) drei Anreicherungstransistoren (M21, M22, M23) umfasst.

5. Spannungsreferenzschaltung nach Anspruch 1, ***dadurch gekennzeichnet, dass*** es sich bei den Transistoren um GaN-Transistoren handelt.

## Claims

1. Voltage reference circuit (1000, 1001, 1002) comprising:
- a first branch (101) comprising:
• a first depletion-mode top transistor (M1), the drain of which is connected to a voltage source (Vcc),
• a first enhancement-mode bottom transistor (M3), the source of which is connected to the ground, the drain of which is connected, on the one hand, to the gate of the top transistor (M1), and on the other hand, the gate of said bottom transistor (M3), and
• a dipole (D1, D11, D21), a first terminal (Q1, Q11) of which is connected to the source of the top transistor (M1) and the second terminal (Q2, 21) of which is connected to the drain of the first bottom transistor (M3), and
- a second branch (102) comprising:
• a second depletion-mode top transistor (M4), the drain of which is connected to the voltage source (Vcc), the source of which is connected to the drain of a third depletion-mode transistor (M5), and the gate of which is connected to the source of said third depletion-mode transistor (M5), and
• a second enhancement-mode bottom transistor (M7), the source of which is connected to the ground, and the drain of which is connected to the source of the third depletion-mode transistor (M5),
the source of the first top transistor (M1) of the first branch (101) being connected to the gate of the third depletion-mode transistor (M5) of the second branch (102), the gates of the first bottom transistor (M3) of the first branch (101) and of the second bottom transistor (M7) of the second branch (102) being connected so as to form a current mirror, the reference voltage (Vref) being provided to the source of the second top transistor (M4) of the second branch (102).

2. Voltage reference circuit according to claim 1, ***characterised in that*** the dipole (D1) is a depletion-mode transistor (M2), the drain of which is connected, on the one hand, to the gate of said enhancement-mode transistor (M2), and on the other hand, to the first terminal (Q1) of the dipole (D1), and the source of which is connected to the second terminal (Q2) of the dipole (D1).

3. Voltage reference circuit according to claim 1, ***characterised in that*** the dipole (D21) comprises n enhancement-mode transistors (M31, M3n), each of said enhancement-mode transistors (M31-M3n) having its gate connected to its drain, said enhancement-mode transistors (M31-M3n) being connected in series, two consecutive transistors (M31-M3n) being connected by the source of one and the drain of the other and, the drain of the first transistor (M31) forming the first terminal (Q21) of the dipole (D21) and the source of the last transistor (M3n) forming the second terminal (Q22) of the second dipole (D21).

4. Voltage reference circuit according to claim 4, ***characterised in that*** the dipole (D11) comprises three enhancement-mode transistors (M21, M22, M23).

5. Voltage reference circuit according to claim 1, ***characterised in that*** the transistors are GaN transistors.
